# EUROPEAN PATENT APPLICATION

(11) **EP 3 270 411 A1**
(43) Date of publication of application: **17.01.2018**
(21) Application number: 17189518.8
(22) Date of filing: 20.06.2016
(51) Int. Cl.: H01L 21/768, H01L 23/532

(54) **METHOD FOR PRODUCING AN INTEGRATED CIRCUIT DEVICE WITH ENHANCED MECHANICAL PROPERTIES**

(30) Priority: 08.07.2015 EP 15175863
(62) Divisional of application: 16175260.5
(71) Applicant: IMEC vzw, 3001 Leuven (BE)
(72) Inventor: DE WOLF, Ingrid, 3001 Leuven (BE); BOEMMELS, Juergen, 3001 Leuven (BE)
(74) Representative: Patent Department IMEC

(57) **Abstract**

The present invention is related to a method for producing an integrated circuit device, comprising a Front-end-of-line (FEOL) portion and a Back-end-of-line (BEOL) portion. The metallization layers comprise dielectric layers, preferably low-k dielectric layers, with metal conductors and/or interconnect structures incorporated within said dielectric layers. In the method of the invention, a mask layer is applied on the BEOL stack or on one of the metallization layers during fabrication of the stack, said mask layer covering portions of the stack area and exposing other portions of said area. Then a treatment is performed that changes the elastic modulus of the dielectric material in one or more of the metallization layers, but only in the areas not covered by the mask layer.

## Description

### Field of the Invention

The present invention is related to the production of an integrated circuit (IC) device, also referred to in this description as a chip or semiconductor chip, in particular to process steps which improve the mechanical properties of dielectric materials applied in the IC device, in order to reduce the risk of Chip Package Interaction (CPI).

### State of the art

Low-k dielectrics, in particular porous low-k materials, are introduced in the back-end-of-line (BEOL) portion of an IC device, to lower the k-value (the dielectric constant) and thereby minimize time delay in the interconnection of the circuitry. Sub-32 nm technology requires ultralow-k porous dielectric materials (k<2.5) for Cu interconnects in the back-end of line to reduce the RC delay. However, although the k-value decreases with increasing porosity, as required to minimize RC delay, the mechanical strength of these materials is also reduced, making them susceptible to mechanical damage (cracks, delamination). The packaging process can, due to a mismatch in the coefficient of thermal expansion (CTE) of different materials, cause large shear forces acting especially at the corners of the chip in the BEOL portion, which may lead to cracks in said BEOL portion. In addition, new packaging technology related processes such as micro-bumps, Cu pillars, TSVs introduce local stress in the BEOL portion which can also lead to damage of the weak low-k material underneath. All these problems are typically described as Chip Package Interaction (CPI). With thinning and stacking of chips for 3D technology, this problem becomes even worse. Any mechanical force can very quickly lead to failure of the BEOL layers.

Existing solutions which address CPI related problems include the use of adhesion layers or crack stoppers, adapting the material used for packaging to reduce CTE mismatch, applying stress mitigation or adapting processing temperatures. All these solutions however have a large impact on the structure and/or the process conditions and may thereby generate other disadvantages. There is a need therefore for an alternative method for mitigating CPI problems.

### Summary of the invention

The present invention is related to a method for producing an integrated circuit device, comprising a Front-end-of-line (FEOL) portion comprising a plurality of transistors and/or other semiconductor components, and a Back-end-of-line (BEOL) portion, comprising a stack of metallization layers for connecting the FEOL portion to external input/output terminals. The metallization layers comprise dielectric layers, preferably low-k dielectric layers, with metal conductors and/or interconnect structures incorporated within said dielectric layers. In the method of the invention, a mask layer is applied on the BEOL stack or on one of the metallization layers during fabrication of the stack, said mask layer covering portions of the stack area and exposing other portions of said area. Then a treatment is performed that changes the elastic modulus of the dielectric material in one or more of the metallization layers, but only in the areas not covered by the mask layer.

The method and device of the invention are set out in the appended claims. As such the invention is firstly related to a method for producing an integrated circuit device comprising a Front-End-Of-Line portion and a Back-End-Of-Line portion, the BEOL portion comprising a metallization stack comprising metallization layers, each metallization layer comprising a layer of dielectric material with metal lines and/or metal vias embedded in the dielectric layer, the stack having a stack surface area, the method comprising the steps of :
- building the metallization stack by a sequence of processing steps wherein subsequent metallization layers are formed,
- During or after said sequence, producing a mask layer on the partially or fully completed stack, the mask layer covering one or more portions of said stack surface area and leaving one or more portions of said stack surface area exposed,
- performing a treatment that changes the elastic modulus of the dielectric material of one or more of said metallization layers on which the mask layer is produced, only in said exposed portion(s) of the stack surface area.
In the above method, 'changing the elastic modulus' of a dielectric layer in exposed areas of the mask layer does not include complete removal of the dielectric material in said exposed areas.

According to one embodiment, the stack is produced by a sequence of process steps, each step comprising:
- depositing a layer of said dielectric material,
- forming the metal lines and/or vias in said dielectric layers by a trench formation and a trench filling process,
and wherein the mask layer is produced on one of the dielectric layers, before or after the trench formation and filling processes.

According to another embodiment, the stack is formed by a sequence of process steps, each step comprising:
- depositing a metal layer,
- patterning the metal layer to form said metal lines and/or vias,
- depositing the dielectric material to form said metallization layers,
and wherein the mask layer is produced on one of said metallization layers, after deposition of the dielectric material.

According to a preferred embodiment, the dielectric material is a porous low-k material.

According to a first embodiment, the dielectric material of said layer on which the mask layer is produced is a porous low-k dielectric material, and wherein the treatment comprises :
- applying a liquid pore-filling material to the exposed portion (s) of the stack surface area, so as to allow said liquid to penetrate the pores of the dielectric material of said dielectric layer on which the mask layer is produced, in said exposed areas,
- a heating step to a temperature above the glass-forming temperature of the pore-filling material, thereby increasing the elastic modulus of the dielectric material in the exposed areas of said dielectric layer on which the mask layer is produced.

According to a second embodiment, the dielectric material of said layer on which the mask layer is produced is a porous low-k material comprising a porogen in the pores of the material, and wherein the treatment is a porogen-removing treatment, configured to remove at least an amount of said porogen from the pores in the exposed portion(s) of the dielectric layer on which the mask layer is produced, thereby decreasing the elastic modulus of the dielectric material in said exposed portions.

The mask layer may be a metal layer. According to another embodiment, the mask layer is a polymer layer.

According to an embodiment, a redistribution layer is applied on top of the metallization stack, said redistribution layer comprising metal structures for connecting the metallization stack to structures that are external to the device, and said metal portions are used as the mask layer.

According to an embodiment, the covered or exposed portion comprises a sub-portion of the stack surface area that comprises a strip running along and including the edge of the stack surface area, and wherein the treatment is chosen so that in at least one of the metallization layers, the dielectric material has a higher elastic modulus in said sub-portion of the stack surface area compared to the dielectric material adjacent to said sub-portion.

According to an embodiment, the mask layer is a shadow mask that is removably positioned in contact with or at a distance from a layer of said partially or fully completed stack or on a passivation layer present on top of said stack.

The present disclosure is equally related to an Integrated circuit device comprising a Front-End-Of-Line portion and a Back-End-Of-Line portion, the BEOL portion comprising a metallization stack of metallization layers, each metallization layer comprising a dielectric layer with metal lines and/or metal vias embedded in the dielectric layer, wherein in at least one of the metallization layers of the metallization stack, the elastic modulus of the dielectric layer varies from one area of the dielectric layer to one or more other areas of the dielectric layer. Said IC device is obtainable by the method of the invention. In an IC device according to the invention, areas with an E-modulus that differs from the E-modulus of other areas do not include areas where the dielectric material has been completely removed.

### Brief description of the figures

Figure 1 illustrates the various layers and components that form the FEOL and BEOL portions of an IC device.
Figure 2 shows an embodiment of a mask layer applied on the passivation layer of an IC device, suitable for strengthening the dielectric material in the BEOL portion in an edge area of the IC.
Figure 3 shows a number of different mask designs applied on a plurality of IC devices.

### Detailed description of the invention

Throughout this detailed description, unless specifically specified, the description of a layer being present, deposited or produced 'on' another layer or substrate, includes the options of
- said layer being present, produced or deposited directly on, i.e. in physical contact with, said other layer or substrate, and
- said layer being present, produced or deposited on one or a stack of intermediate layers between said layer and said other layer or substrate, and
- said layer being removably positioned above said other layer or substrate, either directly on, i.e. in physical contact with said other layer or substrate or at a non-zero distance from said other layer or substrate.

In the context of the present description, low-k materials are defined as dielectrics which have a lower dielectric constant than silicon dioxide (SiO₂). In many of the embodiments of the method of the invention, the material of interest is porous low-k dielectric material, which may be an oxide of a semiconductor material treated to obtain increased pore size and thereby further lower the dielectric constant. Porous low-k dielectric material may be produced by a solgel technique or by deposition of an oxide layer, e.g. by Chemical Vapour Deposition, together with a porogen, a material that can be removed after deposition of the layer so as to create the pores. The treatments used to remove porogens include UV radiation and a plasma treatment, e.g. an atomic hydrogen cure from a remote H₂/He plasma at 275 °C and 50 Pa (treatment referred to as ash cure). These treatments are known, as illustrated for example by the document "Mechanical property changes in porous low-k dielectric thin films during processing", G. Stan et al, Applied Physics Letters 105, 152906 (2014). Within the present context, a porous low-k material is a material with porosity higher than about 10% and up to about 60%, more preferably higher than about 20% and up to about 60% even more preferably higher than about 30% and up to about 60%.

Methods are furthermore known in the state of the art which are configured to increase the elastic modulus of a low-k material. UV curing is known to increase the stiffness of the organosilicate skeleton of a porous SiOC:H layer, see above-cited article by Stan et al. The same article describes increasing the elastic modulus of a porous low k dielectric by filling up the pores with a polymer. This may be done by spin coating a polymer on top of a porous low-k layer and heating the layer to temperatures above the glass forming temperature of the polymer.

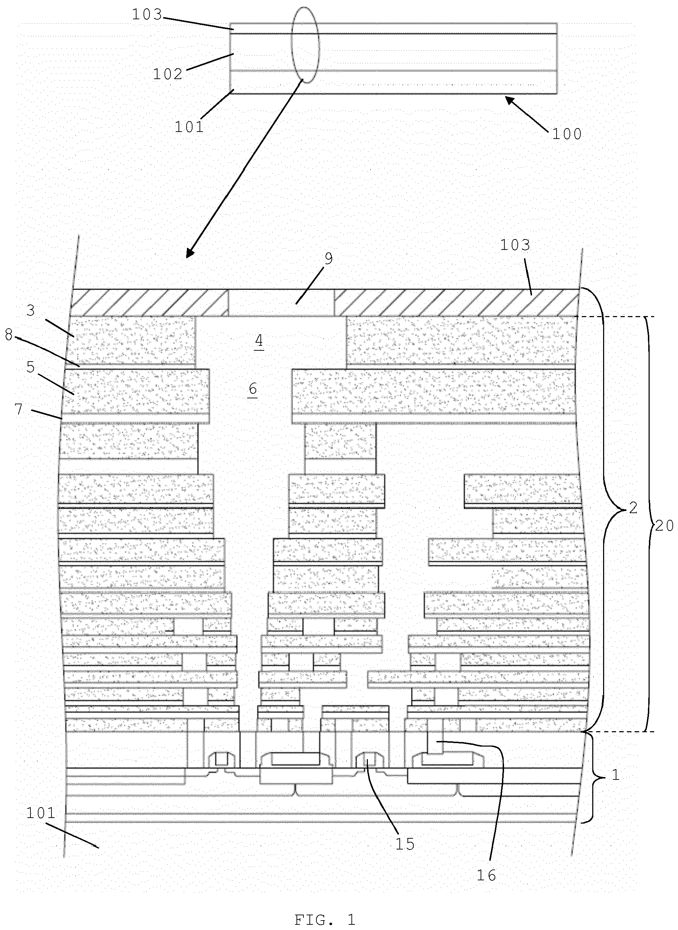

The present invention applies some of these methods in combination with a mask layer to obtain local changes of the elastic modulus of a dielectric layer applied in the BEOL portion of a chip. In order to define some of the terminology used in the present description, reference is made to Figure 1 which shows a typical structure of an integrated circuit device 100, comprising a base substrate 101, a FEOL/BEOL portion 102 and a passivation layer 103. The base substrate 101 may be the thinned portion of a silicon wafer onto which the chip has been produced. The enlarged view illustrates details of these various constituent elements, in particular of the FEOL portion 1 and of the BEOL portion 2. The FEOL portion 1 is obtainable through any known semiconductor process suitable for this purpose and may comprise a plurality of transistors 15 or other active elements, connected to the BEOL portion by metal connection plugs 16. The BEOL portion 2 comprises a stack 20 of metallization layers, each layer comprising a dielectric with metal structures embedded in the dielectric material. Layers 3 comprising metal lines 4 are adjacent to layers 5 comprising metal via connections 6 (hereafter referred to as 'vias') connecting the lines 4 to layers that are higher or lower in the stack. Etch stop layers 7 or dielectric capping layers 8 separate adjacent metallization layers. The fabrication of these metallization layers is known per se, and may involve deposition of a dielectric layer followed by creation of trenches and openings, depositing a barrier layer and nucleation layer and electroplating copper for filling the trenches (known as single or double damascene processing). Inversely, the metallization layers 3/5 may be produced by deposition of a metal layer, patterning the metal layer to form the metal lines 4 and/or vias 6, and filling the formed open areas with dielectric material (so-called subtractive process, see further). On top of the device, covering the metallization stack 20 is a passivation layer 103 comprising metal connections 9 for connecting the metal lines and/or vias 4/6 of the BEOL portion 2 to contact structures external to the IC.

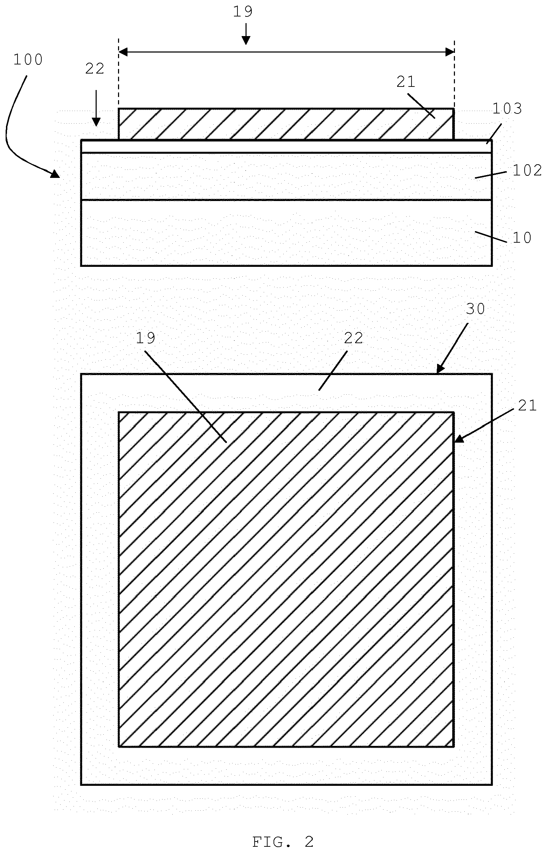

Figure 2 illustrates one IC device 100 as produced on a semiconductor substrate 10, preferably a silicon wafer. The IC is thus still attached to the larger wafer, preferably along with a plurality of other ICs (not shown) that have been produced in said wafer. The stack surface area 30 of the IC is defined as the footprint area of the metallization stack 20 comprised in the BEOL portion, i.e. the area of any cross-section of the stack by a plane parallel to the metallization layers. The invention is related to the use of a mask layer 21 for changing locally the elastic modulus of one or more dielectric layers of the metallization stack 20, so as to obtain local areas with higher E-modulus, improving the overall mechanical properties of the IC, whilst maintaining in other areas a dielectric with good electrical properties (such as low k and/or high porosity).

According to a method that is not a part of the invention, the mask is combined with a UV treatment, applied to metallization layers 3/5 comprising preferably a low k dielectric, more preferably a porous low-k dielectric as defined above. In the embodiment of Figure 2, a mask layer 21 is produced directly on and in contact with the passivation layer 103. The mask layer 21 covers a central portion 19 of the passivation layer 103 and leaves a strip 22 of the passivation layer exposed, said strip 22 running along the edge of the surface area 30. The mask layer 21 thus covers a portion 19 of the surface area 30 of the metallization stack 20, and leaves another portion 22 exposed. The mask 21 is suitable for obstructing UV radiation from reaching the underlying material. The device is then subjected to UV radiation during a time sufficient to realize a strengthening of the dielectric material in each dielectric layer 3/5 of the metallization stack 20, in the exposed area 22 along the edge, i.e. the UV radiation penetrates through the passivation layer 103 and each metallization layer 3/5 of the stack 20.

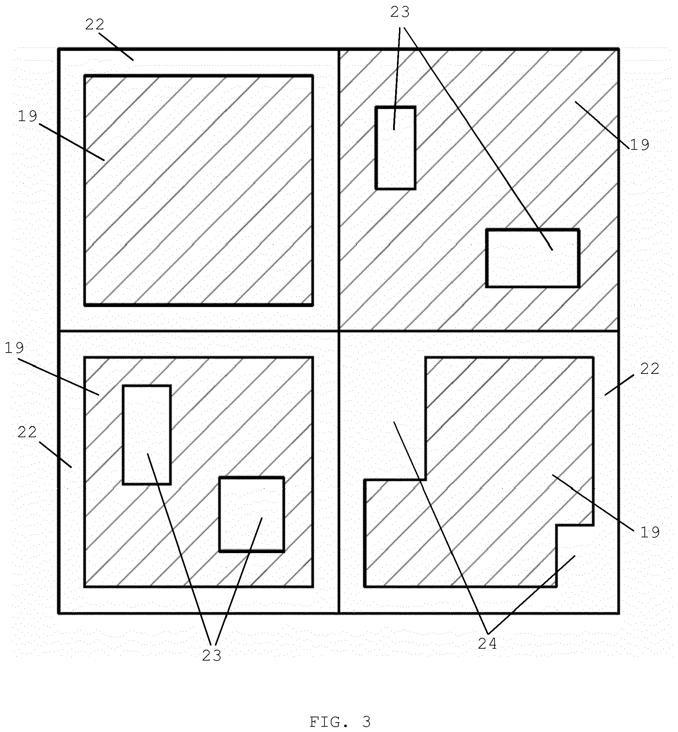

The method is preferably applied before dicing of the IC device, i.e. after the IC 100 has been produced on the surface of a large semiconductor wafer 10, together with a plurality of the same or similar devices, by subsequent deposition and patterning/processing of the FEOL and BEOL layers of all the devices on the wafer. The passivation layer 103 then covers all the devices on the wafer and the mask layer 21 may be applied on the totality of the passivation layer 103 across the complete wafer and patterned on each of the devices, possibly with different mask patterns for each device or each group of devices. Figure 3 shows an example of four chips produced on the same wafer, each with differently patterned mask layers 21 deposited on top of the passivation layer. Instead of or in addition to the mask for strengthening the edge strip 22 of the chip, the mask may be designed to strengthen certain regions 23 within the stack surface area 30, or the circumferential area 22 may comprise wider portions 24. The regions 23 and the wider portions 24 may be areas corresponding to functional areas on the chip, for example areas for which the RC delay is less crucial.

Instead of being applied on the passivation layer 103 for UV-treating the total metallization stack 20 of the BEOL portion, the mask layer 21 could be applied during BEOL processing. As stated above, the fabrication of the metallization layers 3/5 may take place by a damascene process, wherein first a dielectric layer is deposited, followed by trench formation and trench filling processes. The mask layer 21 can be applied on the dielectric layer either before or after the trench formation and trench filling processes. In the first case the mask layer is deposited on a blanket dielectric layer. In the second case the mask layer is deposited on a dielectric layer with metal lines and/or via connections embedded therein.

As stated above, the metallization layers may alternatively be produced by the inverse of a damascene, which may be referred to as a subtractive production process which is known per se, and wherein a metal layer, e.g. Al or Cu, is first deposited, patterned to form the metal lines 4 and/or vias 6, after which the dielectric material is deposited in the open areas created by the patterning process. If the metallization layer is produced in this way, the mask layer 21 may be applied on the metallization layer, after completion of the metallization layer in the above-described way.

In either case (damascene or subtractive process), the UV treatment is performed on the layer on which the mask layer is produced, and on the layers underneath it, thereby strengthening the dielectric material of these layers in the areas that are not covered by the mask. This may be useful for strengthening localized areas within the BEOL stack, for example in the vicinity of a number of via connections at which mechanical stresses are likely to become important.

The IC device may be provided with a so-called redistribution layer (RDL), which is basically a pattern of metal lines and/or contact pads provided on top of the metallization stack 20, for re-routing the terminals 9 of said stack towards more suitable locations at which the chip may be connected to external structures, for example to another chip in a 3D chip stack. The metal structures of the RDL are embedded in a dielectric material which may be the same material used for a traditional passivation layer, so the RDL can be regarded as a passivation layer with additional metal lines and other metal structures compared to a traditional passivation layer. According to an embodiment, the metal pattern of the RDL layer itself is used as a mask in the method of the invention, i.e. the metal portions of the RDL form the mask areas covering the underlying dielectric layers and preventing the dielectric material underneath the covered areas from being strengthened by the UV radiation. The method may thus be performed on the IC, after completion of the RDL, and without applying an additional mask layer on top of the RDL.

The UV radiation is preferably monochromatic at a wavelength between 120nm and 200nm, with further embodiments applying UV between 130nm and 180nm, and between 140nm and 160nm. The wavelength defines the shape of the gradient of the elastic modulus at the border between exposed and non-exposed areas. When the wavelength is too high, this gradient is too gradual, and there is no clear separation between exposed and non-exposed areas. When the wavelength is too low, the gradient is too sharp, which may again be a source of local stresses. The applied UV radiation may be uni-directional in the direction perpendicular to the mask layer, as obtainable by suitable and generally known UV sources. The duration of the UV exposure may be between a few seconds up to several (tens of) minutes, depending on the structure (number of dielectric layers, layer thicknesses, etc).

Instead of a treatment by UV radiation, a treatment by e-beam may be applied for obtaining the same effect of strengthening a dielectric material in the areas not covered by the mask. Still another alternative is an ion beam treatment, for example by Ar or Xe ions.

According to an embodiment of the invention, which is however applicable only on a single porous dielectric layer 3/5, preferably a low k layer, the mask layer 21 is produced directly on said dielectric layer, when the layer has been produced during the BEOL process as described above (i.e. on a full wafer, before dicing). When a damascene process is used, the mask layer 21 may be produced either before or after trench formation and trench filling. When a subtractive process is used, the mask layer is produced after completion of the metallization layer. When the mask layer 21 is in place, a liquid pore-filling polymer is applied on the wafer, for example by spin-coating the polymer on a rotating wafer. The polymer penetrates into the dielectric material in the areas which are not covered by the mask. After heating to a temperature above the glass forming temperature of the polymer, local areas are created in said dielectric layer, consisting of dielectric material with higher elastic modulus.

According to another embodiment, the mask layer 21 is produced directly on a dielectric layer, preferably a low k layer (before or after trench formation and trench filling in a damascene process, or after completion of the metallization layer in a subtractive process), the dielectric material of which was deposited together with a porogen, but wherein the porogen has not been removed, i.e. a layer with a higher elastic modulus compared to a porous dielectric layer. This layer is then subjected to a porogen removal treatment configured to remove the majority of the porogen from the dielectric material in the exposed areas but not from the areas covered by the mask 21. A preferred porogen removal treatment is a downstream H₂ plasma treatment, i.e. including blocking of UV form the plasma discharge. In this way, the elastic modulus is decreased in the exposed areas, leaving stronger areas where the mask is covering the dielectric. The mask design may thus be the inverse of the mask designs shown in Figures 1 and 2, e.g. a mask layer that covers the strip area 22 of the stack surface area and exposes the central portion 19. The shape of the masks shown in Figures 2 and 3 is applicable also in the embodiments involving pore-filling or porogen removal for changing the E-modulus of the dielectric layer.

The pore-filling treatment and the porogen removal treatment as described above may be applied with an RDL layer used as the mask layer, but only if the metal pattern of the RDL is produced before embedding said pattern in a dielectric. This may be done for example when the RDL layer is produced by a subtractive process as referred to above : by depositing a metal layer, patterning the metal layer to form the RDL pattern, and filling the open areas by a dielectric. Before the last step, the RDL pattern could then be used as a mask layer for performing the method according to any embodiment of the invention, including by pore filling and porogen removal in the areas not covered by the RDL pattern.

When the E-modulus is changed by UV treatment, the mask layer 21 is preferably a metal mask, for example a Ti mask. The thickness of a metal mask can be in the order of 50-100nm or less. Alternatively, the mask may be a polymer mask, which needs to be much thicker however, in the order of one micron (e.g. for a mask produced from BCB). When the E-modulus is changed by pore filling or porogen removal, the mask layer 21 may be a metal mask or a polymer mask.

In any of the above-described embodiments, the mask layer 21 may be produced according to known techniques, preferably by deposition of a layer on a wafer carrying a plurality of fully or partially finished chips, followed by a lithographic patterning step to form the mask layer 21 on the chip areas of the wafer. After the treatment for changing the E-modulus in the exposed areas, the mask layer 21 may be removed by an equally known removal technique. In any embodiment, the treatment for changing the E-modulus is performed after producing the mask layer and before further processing steps in the device fabrication process. When the mask layer is deposited directly on a metallization layer 3/5, the mask layer therefore needs to be removed after the treatment and before processing of subsequent layers of the metallization stack. When the mask layer is applied on the passivation layer 103, it may be allowed to remain on the passivation layer after the E-modulus treatment.

Instead of producing a mask layer 21 by deposition and lithography on top of the passivation layer 103 or a dielectric layer 3/5 of the BEOL stack, the mask layer 21 may be a shadow mask. This is a mask that is removably positioned above the layer(s) to be treated, i.e. the mask can be re-used several times When the E-modulus is changed through a UV treatment in combination with a shadow mask, the shadow mask is preferably positioned at a small distance, for example a distance of a few microns from the layer(s) to be treated. The smaller the distance, the sharper will be the gradient between treated and non-treated areas. When the E-modulus is changed through a pore-filling or a porogen removal process in combination with a shadow mask, the shadow mask is preferably positioned in physical contact with the layer to be treated.

## Claims

1. A method for producing an integrated circuit device (100) comprising a Front-End-Of-Line portion (1) and a Back-End-Of-Line portion (2), the BEOL (2) portion comprising a metallization stack (20) comprising metallization layers (3,5), each metallization layer (3,5) comprising a layer of dielectric material with metal lines (4) and/or metal vias (6) embedded in the dielectric layer, the stack (20) having a stack surface area (30), the method comprising the steps of :
• building the metallization stack by a sequence of processing steps wherein subsequent metallization layers (3,5) are formed,
• During or after said sequence, producing a mask layer (21) on the partially or fully completed stack, the mask layer (21) covering one or more portions (19) of said stack surface area (30) and leaving one or more portions (22,23,24) of said stack surface area (30) exposed,
• performing a treatment that changes the elastic modulus of the dielectric material of one or more of said metallization layers on which the mask layer (21) is produced, only in said exposed portion(s) (22,23,24) of the stack surface area (30),
wherein the stack (20) is produced by a sequence of process steps, each step comprising :
• depositing a layer of said dielectric material,
• forming the metal lines (4) and/or vias (6) in said dielectric layers by a trench formation and a trench filling process,
and wherein the mask layer (21) is produced on one of the dielectric layers, before or after the trench formation and filling processes,
**or** wherein the stack (20) is formed by a sequence of process steps, each step comprising :
• depositing a metal layer,
• patterning the metal layer to form said metal lines (4) and/or vias (6),
• depositing the dielectric material to form said metallization layers (3,5),
and wherein the mask layer (21) is produced on one of said metallization layers (3,5), after deposition of the dielectric material,
and wherein the treatment comprise :
• applying a liquid pore-filling material to the exposed portion(s) (22,23,24) of the stack surface area (30), so as to allow said liquid to penetrate the pores of the dielectric material of said dielectric layer on which the mask layer (21) is produced, in said exposed areas (22,23,24),
• a heating step to a temperature above the glass-forming temperature of the pore-filling material, thereby increasing the elastic modulus of the dielectric material in the exposed areas (22,23,24) of said dielectric layer on which the mask layer (21) is produced.

2. A method for producing an integrated circuit device (100) comprising a Front-End-Of-Line portion (1) and a Back-End-Of-Line portion (2), the BEOL (2) portion comprising a metallization stack (20) comprising metallization layers (3,5), each metallization layer (3,5) comprising a layer of dielectric material with metal lines (4) and/or metal vias (6) embedded in the dielectric layer, the stack (20) having a stack surface area (30), the method comprising the steps of :
• building the metallization stack by a sequence of processing steps wherein subsequent metallization layers (3,5) are formed,
• During or after said sequence, producing a mask layer (21) on the partially or fully completed stack, the mask layer (21) covering one or more portions (19) of said stack surface area (30) and leaving one or more portions (22,23,24) of said stack surface area (30) exposed,
• performing a treatment that changes the elastic modulus of the dielectric material of one or more of said metallization layers on which the mask layer (21) is produced, only in said exposed portion(s) (22,23,24) of the stack surface area (30),
wherein the stack (20) is produced by a sequence of process steps, each step comprising :
• depositing a layer of said dielectric material,
• forming the metal lines (4) and/or vias (6) in said dielectric layers by a trench formation and a trench filling process,
and wherein the mask layer (21) is produced on one of the dielectric layers, before or after the trench formation and filling processes, or wherein the stack (20) is formed by a sequence of process steps, each step comprising :
• depositing a metal layer,
• patterning the metal layer to form said metal lines (4) and/or vias (6),
• depositing the dielectric material to form said metallization layers (3,5),
and wherein the mask layer (21) is produced on one of said metallization layers (3,5), after deposition of the dielectric material,
and wherein the dielectric material of said layer on which the mask layer (21) is produced is a porous material comprising a porogen in the pores of the material, and wherein the treatment is a porogen-removing treatment, configured to remove at least an amount of said porogen from the pores in the exposed portion(s) (22,23,24) of the dielectric layer on which the mask layer (21) is produced, thereby decreasing the elastic modulus of the dielectric material in said exposed portions (22,23,24).

3. Method according to claim 1 or 2, wherein the dielectric material on which the mask layer is produced is a low-k material.

4. Method according to any one of claims 1 to 3, wherein the mask layer (21) is a metal layer.

5. Method according to any one of claims 1 to 3, wherein the mask layer (21) is a polymer layer.

6. Method according to any one of the preceding claims, wherein a redistribution layer is applied on top of the metallization stack (20), said redistribution layer comprising metal structures for connecting the metallization stack (20) to structures that are external to the device, and wherein said metal portions are used as the mask layer (21).

7. Method according to any one of the preceding claims, wherein the covered or exposed portion comprises a sub-portion of the stack surface area (30) that comprises a strip (22) running along and including the edge of the stack surface area (30), and wherein the treatment is chosen so that in at least one of the metallization layers (3,5), the dielectric material has a higher elastic modulus in said sub-portion of the stack surface area compared to the dielectric material adjacent to said sub-portion.

8. Method according to any one of the preceding claims, wherein the mask layer (21) is a shadow mask that is removably positioned in contact with or at a distance from a layer of said partially or fully completed stack (20) or on a passivation layer (103) present on top of said stack.
